Europäisches Patentamt

**European Patent Office**

Office européen des brevets

(11) Veröffentlichungsnummer: **0 046 835**
**B1**

(12) # EUROPÄISCHE PATENTSCHRIFT

(45) Veröffentlichungstag der Patentschrift:
06.06.84

(51) Int. Cl.³: **H 03 J 5/02,** H 04 B 1/56

(21) Anmeldenummer: **81101731.8**

(22) Anmeldetag: **10.03.81**

(54) **Vielkanal-Sprechfunkgerät für die Betriebsarten 'Wechselsprechen' und/oder 'bedingtes Gegensprechen'.**

(30) Priorität: **28.08.80 DE 3032378**

(43) Veröffentlichungstag der Anmeldung:
**10.03.82 Patentblatt 82/10**

(45) Bekanntmachung des Hinweises auf die Patenterteilung:
**06.06.84 Patentblatt 84/23**

(84) Benannte Vertragsstaaten:
**AT DE FR GB IT NL**

(56) Entgegenhaltungen:
**DE - A - 2 551 110**
**DE - A - 2 551 110**
**US - A - 3 715 687**
**US - A - 3 715 687**

**"Bosch-Funk, Technische Informationen", Ausgabe
1980, Vielkanal-Sprechfunkgeräte, KF 802**

(73) Patentinhaber: **ROBERT BOSCH GMBH, Postfach 50,
D-7000 Stuttgart 1 (DE)**

(72) Erfinder: **Katzy, Bernhard-Michael, Dipl.-Ing.,
Behaimstrasse 7, D-1000 Berlin 10 (DE)**

(74) Vertreter: **Schmidt, Hans-Ekhardt, Robert Bosch GmbH
Geschäftsbereich Elektronik Patent- und
Lizenzabteilung Forckenbeckstrasse 9-13,
D-1000 Berlin 33 (DE)**

BUNDESDRUCKEREI BERLIN

**Beschreibung**

Die Erfindung geht aus von einem Vielkanal-Sprechfunkgerät nach der Gattung des Hauptanspruchs.

Es sind Vielkanal-Sprechfunkgeräte bekannt (vgl. »Bosch-Funk, Technische Informationen«, Ausgabe 1980, Vielkanal-Sprechfunkgeräte KF 802), die für die Betriebsarten »Wechselsprechen« und/oder »bedingtes Gegensprechen« geeignet sind. Der jeweils gewünschte Funkkanal wird mit einer Kanaltaste eingestellt, durch die eine PROM-(programmable-read-only-memory-)Speicherschaltung angesteuert wird. Die PROM-Speicherschaltung gibt an ihrem Ausgang kodierte Signale ab, die zum Ansteuern einer PLL-(phase-locked-loop-)Oszillatorschaltung dienen. Die PROM-Speicherschaltung ist derart programmiert, daß sie nur Kodesignale für zugelassene Funkkanäle abgibt. Der Kanalabstand beträgt wahlweise 20 oder 25 kHz. Ein derartiges Vielkanal-Sprechfunkgerät hat den Nachteil, daß es fest abgestimmte, bei der Betriebsart »bedingtes Gegensprechen« auf das Oberband oder Unterband umschaltbare Eingangskreise mit einer Schaltbandbreite von bis zu 5 MHz aufweist. Eine universelle Anwendbarkeit des Vielkanal-Sprechfunkgerätes in dem gesamten zur Verfügung stehenden Sprechfunk-Frequenzbereich ist somit nicht möglich.

Das erfindungsgemäße Vielkanal-Sprechfunkgerät mit den kennzeichnenden Merkmalen des Hauptanspruchs hat den Vorteil, daß die Hochfrequenz-Eingangskreise des Sprechfunkgerätes für jeden gewählten Funkkanal optimal abgestimmt werden.

Durch die in den Unteransprüchen aufgeführten Maßnahmen sind vorteilhafte Weiterbildungen und Verbesserungen des im Hauptanspruch angegebenen Vielkanal-Sprechfunkgerätes möglich. Besonders vorteilhaft ist ein Vielkanal-Sprechfunkgerät, bei dem die logische Verknüpfungsschaltung Schaltmittel enthält, mit denen durch Differenzbildung zwischen einer Referenzspannung, deren Größe von der Betriebsart, dem Frequenzband (Oberband oder Unterband) und dem Kanalraster abhängt, und einer aus dem ersten Digitalwert abgeleiteten analogen Spannung die Steuerspannung erzeugt wird. Auf diese einfache Weise kann eine Steuerspannung bereitgestellt werden, die den Selektionskreis oder die Selektionskreise des Empfangsteils des Sprechfunkgerätes exakt auf die Empfangsfrequenz abstimmt.

Ein Ausführungsbeispiel der Erfindung ist in der Zeichnung anhand zweier Figuren dargestellt und in der nachfolgenden Beschreibung näher erläutert. Die Zeichnung zeigt in

Fig. 1 ein stark vereinfachtes Blockschaltbild eines Empfangsteils eines erfindungsgemäßen Vielkanal-Sprechfunkgerätes und

Fig. 2 ein ausführlicheres Blockschaltbild zu Fig. 1.

Ein erfindungsgemäßes Vielkanal-Sprechfunkgerät hat eine Kanalschaltereinrichtung 10 mit einer Kanaltaste 11, einem Betriebsartenschalter 12 mit den Schalterstellungen Wechselsprechen (W), Oberband (OB) und Unterband (UB), eine Kodiereinrichtung 13 und eine digitale Anzeigevorrichtung 14.

Die Kodiereinrichtung 13 ist mit einer PROM-(programmable-read-only-memory-)Speicherschaltung 15 verbunden. Von der PROM-Speicherschaltung führen eine erste, zweite und dritte Leitungsverbindung 16, 17 und 21 an eine PLL-(phase-locked-loop-)Oszillatorschaltung 18, deren Ausgang mit einer Mischstufe des Empfangsteils des Sprechfunkgerätes in Verbindung steht. Ein erster, zweiter und dritter Abzweig 160, 170 und 210 der ersten bis dritten Leitungsverbindung 16, 17 und 21 führen an eine logische Verknüpfungsschaltung 22, die folgende Baustufen umfaßt. Ein mit den Abzweigen 160, 170 und 210 verbundener Auswerter 23 steht mit einem Referenzspannungsschalter 24 in Verbindung, dessen Ausgang 25 mit einem nichtinvertierenden Eingang eines als Differenzverstärker geschalteten Operationsverstärkers 26 verbunden ist. Mit dem Abzweig 160 bzw. der ersten Leitungsverbindung 16 ist weiterhin über eine Anpassungsstufe 27 ein Digital/Analog-Wandler 28 verbunden, dessen Ausgang 29 mit einem invertierenden Eingang des Operationsverstärkers 26 in Verbindung steht. Die Anpassungsstufe 27 ist eine zum Beispiel durch einen Pufferkreis gebildete Stufe zum Anpassen des Ausgangssignalpegels der PROM-Speicherschaltung 15 an den Eingang des Digital/Analog-Wandlers 28 und/oder einer Stufe zum Anpassen des Digitalwertes auf der ersten Leitungsverbindung 16 an den für den Digital/Analog-Wandler 28 benötigten Eingangs-Digitalwert. An einen Ausgang 30 des Operationsverstärkers 26 schließt sich eine elektronisch abstimmbare Selektionsschaltung 31 an, das ist zum Beispiel ein Hochfrequenz-Eingangskreis 32, dessen Kapazität zu einem Teil von einer Kapazitätsvariationsdiode 33 gebildet wird.

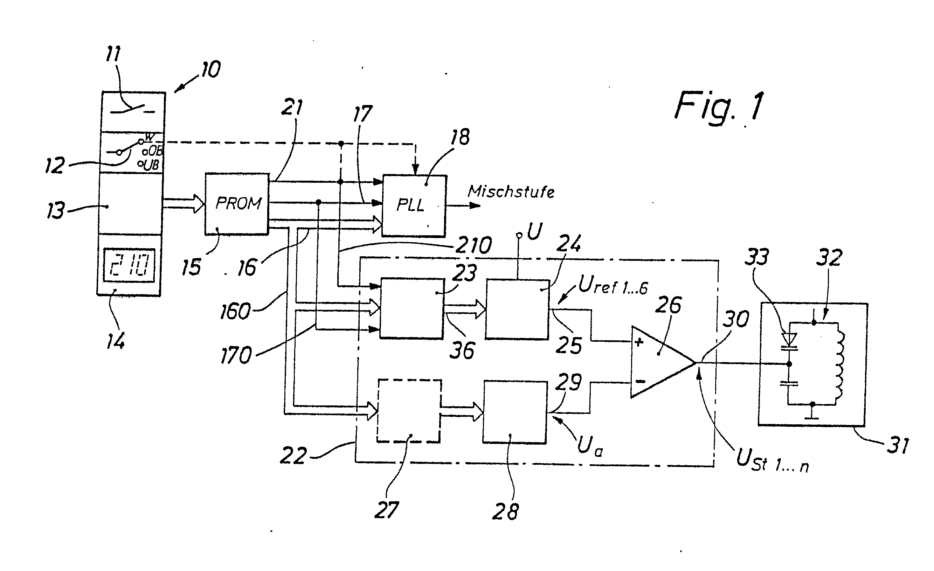

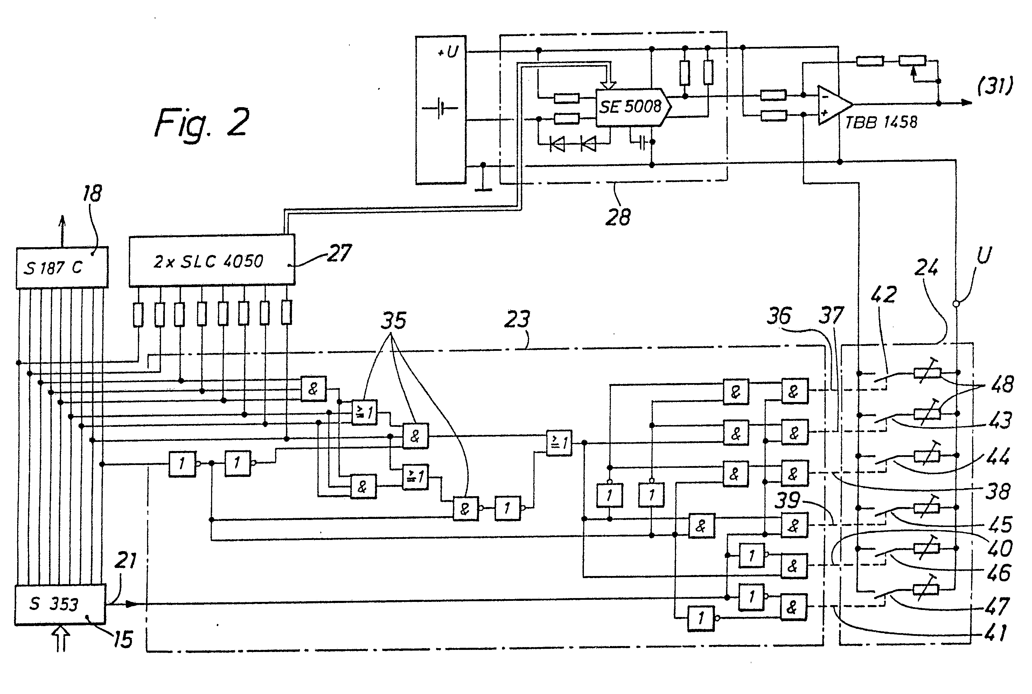

In dem ausführlicheren Blockschaltbild in Fig. 2 sind der Fig. 1 entsprechende Baustufen mit gleichen Bezugszahlen bezeichnet. Die Wirkungsweise der in den Fig. 1 und 2 beschriebenen Schaltung ist folgende.

Befindet sich der Betriebsartenschalter 12 in der Schalterstellung Oberband (OB) oder Unterband (UB) und ist mit der Kanaltaste 11 bzw. den Kanaltasten ein bestimmter Funkkanal aus einer Vielzahl von Funkkanälen ausgewählt worden, zum Beispiel der Funkkanal 210, so gibt die Kodiereinrichtung 13 eine digitale Information, zum Beispiel im BCD-Kode, ab, die erstens die Empfangsfrequenz des eingestellten Funkkanals, zweitens die gewählte Betriebsart (Wechselsprechen oder bedingtes Gegensprechen) und drittens das gewählte Band (Oberband oder Unterband) zum Inhalt hat. Diese Information wird der PROM-Speicherschaltung 15 zugeführt.

Die PROM-Speicherschaltung ist erstens derart programmiert, daß sie entsprechend dem gewählten Funkkanal — sofern dies überhaupt ein zulässiger Funkkanal ist — einen Digitalwert über die erste Leitungsverbindung 16 an die PLL-Schaltung 18 abgibt. Der Digitalwert entspricht einem bestimmten Teilungsverhältnis, durch das die PLL-Oszillatorschaltung derart beeinflußt wird, daß sie an ihrem Ausgang eine bestimmte Oszillatorfrequenz abgibt, die in einer Mischstufe des Empfangsteils des Sprechfunkgerätes mit der jeweiligen Empfangsfrequenz gemischt wird und eine (erste) Zwischenfrequenz bildet. Die PROM-Speicherschaltung ist zweitens derart programmiert, daß sie über die zweite Leitungsverbindung 17 einen Digitalwert an die PLL-Oszillatorschaltung abgibt, der bewirkt, daß die erzeugten Oszillatorfrequenzen in dem gewünschten Frequenzraster liegen. Die PROM-Speicherschaltung liefert außerdem über die Leitungsverbindung 21 ein die gewählte Betriebsart kennzeichnendes Signal. Das zuletzt genannte Signal kann gegebenenfalls auch unmittelbar von dem Betriebsartenschalter 12 abgeleitet werden; vgl. in Fig. 1 gestrichelt eingezeichnete Leitungsverbindungen. Der Abstand zwischen den einzelnen Funkkanälen, das heißt das Frequenzraster, beträgt beispielsweise 20 kHz oder 25 kHz.

Anhand der über die erste bis dritte Leitungsverbindung 16, 17, 21 und die Abzweige 160, 170, 210 an die logische Verknüpfungsschaltung 22 herangeführten Signale trifft der Auswerter 23 folgende Unterscheidungen: er stellt fest, ob die Betriebsart »Wechselsprechen« oder »bedingtes Gegensprechen«, ob eine Frequenz des Oberbandes oder des Unterbandes und welches Kanalraster mit der Kanalschaltereinrichtung gewählt worden ist. Für diese Unterscheidungen ist eine Reihe von logischen Verknüpfungsgliedern 35 erforderlich. Der Auswerter 23 gibt an seinen Ausgängen ein Ausgangssignal ab, mit dem der Referenzspannungsschalter 24 angesteuert wird. In dem Ausführungsbeispiel nach Fig. 2 hat der Auswerter 23 sechs Ausgänge 36 bis 41, von denen die Ausgänge 36 und 37 dem Oberband bzw. Unterband des 20-kHz-Rasters, die Ausgänge 38 und 39 dem Unterband bzw. Oberband des 25-kHz-Rasters und die Ausgänge 40 und 41 den Wechselsprechfrequenzen im 25-kHz-Raster bzw. im 20-kHz-Raster entsprechen.

In dem Referenzspannungsschalter 24 ist jedem der Ausgänge 36 bis 41 ein durch das Ausgangssignal steuerbarer elektronischer Schalter 42 bis 47 zugeordnet, mit dem je ein Einstellwiderstand 48 eingeschaltet werden kann. Die Einstellwiderstände 48 liegen mit ihrem einen Anschluß an einem festen Gleichspannungspotential U und mit ihrem anderen Anschluß über je einen der Schalter 42 bis 47 an dem nichtinvertierenden Eingang des Oparetionsverstärkers 26. Durch verschiedene Einstellungen der Einstellwiderstände 48 liegt an dem nichtinvertierenden Eingang des Operationsverstärkers 26, je nachdem, welcher der Schalter 42 bis 47 geschlossen ist, eine von mehreren Referenzspannungen $U_{ref1 \ldots 6}$.

Der von der Leitungsverbindung 16 bzw. dem Abzweig 160 an die Anpassungsstufe 27 geführte, von der gewünschten Frequenz abhängige Digitalwert wird beispielsweise in der Anpassungsschaltung in einen entsprechend anderen Digitalwert umgewandelt, mit dem der Digital/Analog-Wandler 28 angesteuert werden kann. Am Ausgang 29 des Digital/Analog-Wandlers 28 steht eine Ausgangsspannung $U_a$, deren Spannungswert von der gewünschten Frequenz abhängt. Durch Subtraktion der Spannungen $U_a$ und $U_{ref}$ mittels des Operationsverstärkers 26 erhält man am Ausgang 30 des Operationsverstärkers eine der Steuerspannungen $U_{St1 \ldots n}$. Die jeweilige Steuerspannung wird der Kapazitätsvariationsdiode 33 derart zugeführt, daß sich deren Kapazitätswert derart ändert, daß der Selektionskreis auf die gewünschte Resonanzfrequenz (Empfangsfrequenz) abgestimmt wird.

Befindet sich der Betriebsartenschalter 12 in der Schalterstellung »Wechselsprechen« (W), so gibt die PROM-Speicherschaltung 15 an die dritte Verbindungsleitung 21 ein die Betriebsart kennzeichnendes Signal ab, das von dem Auswerter 23 erkannt wird. In Verbindung mit dem durch den Auswerter ebenfalls festgestellten Kanalraster von zum Beispiel 20 kHz oder 25 kHz wird dann einer der Schalter 46, 47 geschlossen und eine dem Wechselsprechen und dem betreffenden Raster entsprechende Referenzspannung $U_{ref5}$ oder $U_{ref6}$ erzeugt. Parallel dazu liefert der Digital/Analog-Wandler 28 eine Ausgangsspannung $U_a$, die von dem gewählten Kanal bzw. der gewünschten Frequenz abhängt. Durch Differenzbildung in dem Operationsverstärker 26 erhält man dann eine Steuerspannung $U_{St}$, die den Selektionskreis 31 in der bereits obenerwähnten Weise abstimmt.

## Patentansprüche

1. Vielkanal-Sprechfunkgerät für die Betriebsarten »Wechselsprechen« und/oder »bedingtes Gegensprechen« mit einer PROM-(programmable-read-only-memory)Speicherschaltung (15), die einen die gewählte Frequenz kennzeichnenden ersten Digitalwert und einen dem vorgegebenen und in der PROM-Speicherschaltung gespeicherten Kanalraster entsprechenden zweiten Digitalwert an eine PLL-(phase-locked-loop-)Oszillatorschaltung (18) abgibt, die eine Mischstufe des Empfangsteils speist, dadurch gekennzeichnet, daß der erste und der zweite Digitalwert sowie ein ebenfalls von der PROM-Speicherschaltung (15) oder von dem Betriebsartenschalter (12) gelieferter, die Betriebsart kennzeichnender dritter Digitalwert der PLL-Schaltung (18) sowie einer logischen Verknüpfungsschaltung (22) zugeführt werden, die aus den Digitalwerten eine entsprechende Steuerspannung ($U_{St}$) an mindestens einen auf die Empfangsfrequenz elektronisch abstimmbaren Selektionskreis (31) des Empfangsteils des Sprechfunkgerätes abgibt.

2. Vielkanal-Sprechfunkgerät nach Anspruch 1, dadurch gekennzeichnet, daß die logische Verknüpfungsschaltung (22) Schaltmittel enthält, mit denen durch Differenzbildung zwischen einer Referenzspannung ($U_{ref}$), deren Größe von der Betriebsart, dem Frequenzband (Oberband, Unterband) und dem Kanalraster abhängt, und einer aus dem ersten Digitalwert abgeleiteten analogen Spannung ($U_a$) die Steuerspannung ($U_{St}$) erzeugt wird.

3. Vielkanal-Sprechfunkgerät nach Anspruch 1 oder 2, dadurch gekennzeichnet, daß die logische Verknüpfungsschaltung (22) einen Auswerter (23) enthält, der anhand der Digitalwerte erstens die Unterscheidung zwischen den Betriebsarten, zweitens die Unterscheidung nach Oberband und Unterband und drittens die Unterscheidung nach Kanalraster durchführt und der an seinen Ausgängen entsprechende digitale Steuersignale abgibt.

4. Vielkanal-Sprechfunkgerät nach Anspruch 1 oder 2, dadurch gekennzeichnet, daß die logische Verknüpfungsschaltung (22) einen Referenzspannungschalter (24) enthält, der in Abhängigkeit von den Steuersignalen des Auswerters (23) eine bestimmte Referenzspannung ($U_{ref}$) an seinem Ausgang (25) abgibt.

5. Vielkanal-Sprechfunkgerät nach Anspruch 1, 2 oder 3, dadurch gekennzeichnet, daß die logische Verknüpfungsschaltung (22) einen Digital/Analog-Wandler (28) enthält, der den ersten Digitalwert in eine analoge Spannung ($U_a$) umwandelt.

6. Vielkanal-Sprechfunkgerät nach Anspruch 5, dadurch gekennzeichnet, daß dem Digital/Analog-Wandler (28) zwecks Anpassung an die PROM-Speicherschaltung (15) eine Anpassungsstufe (27) vorgeschaltet ist.

7. Vielkanal-Sprechfunkgerät nach Anspruch 6, dadurch gekennzeichnet, daß die Anpassungsstufe (27) ein Pufferkreis (buffer circuit) zur Pegelanpassung zwischen der PROM-Speicherschaltung (15) und dem Digital/Analog-Wandler (28) ist.

8. Vielkanal-Sprechfunkgerät nach Anspruch 6, dadurch gekennzeichnet, daß die Anpassungsstufe (27) ein Digitalwert-Wandler ist, der den ersten Digitalwert derart umwandelt, daß er in den Arbeitsbereich des Digital/Analog-Wandlers (28) fällt.

9. Vielkanal-Sprechfunkgerät nach einem der Ansprüche 1 bis 7, dadurch gekennzeichnet, daß die Referenzspannung ($U_{ref}$) und die analoge Spannung ($U_a$) je einem Eingang eines als Differenzverstärker geschalteten Operationsverstärkers (26) zugeführt werden, dessen Ausgangsspannung die Steuerspannung ($U_{St}$) für den Selektionskreis (31) bzw. die Selektionskreise ist.

## Claims

1. A multi-channel radio telecommunication apparatus for the operating modes »two-way speech communication« and/or »alternating duplex communication«, having a PROM (programmable-read-only-memory) storage circuit (15) which supplies a first digital value, characterising the selected frequency, and a second digital value, corresponding to the predetermined channel raster stored in the PROM storage circuit, to a PLL (phase-locked-loop) oscillator circuit (18) which feeds a mixing stage of the receiving part, characterized in that the first and the second digital values and a third digital value which is also supplied by the PROM storage circuit (15) or by the operating mode switch (12) and which characterises the operating mode, are fed to the PLL circuit (18) and to a logic combination circuit (22) which supplies from the digital values a corresponding control voltage ($U_{St}$) to al least one selection circuit (31), electronically tunable to the receiving frequency, of the receiving part of the radio telecommunication apparatus.

2. A multi-channel radio telecommunication apparatus as claimed in claim 1, characterized in that the logic combination circuit (22) includes switching means by which the control voltage ($U_{St}$) is produced by forming the difference between a reference voltage ($U_{ref}$) whose magnitude depends upon the operating mode, upon the frequency band (upper band, lower band) and upon the channel raster, and an analog voltage ($U_a$) derived from the first digital value.

3. A multi-channel radio telecommunication apparatus as claimed in claim 1 or 2, characterized in that the logic combination circuit (22) includes an evaluator (23) which, with reference to the digital values, firstly makes a distinction between the operating modes, secondly makes a distinction between the upper band and the lower band, and thirdly makes a distinction with respect to the channel raster, and supplies corresponding digital control signals at its outputs.

4. A multi-channel radio telecommunication apparatus as claimed in claim 1 or 2, characterized in that the logic combination circuit (22) includes a reference voltage switch (24) which produces a specific reference voltage ($U_{ref}$) at its output (25) in dependence upon the control signals of the evaluator (23).

5. A multi-channel radio telecommunication apparatus as claimed in claim 1, 2 or 3, characterized in that the logic combination circuit (22) includes a digital-to-analog converter (28) which converts the first digital value to an analog voltage ($U_a$).

6. A multi-channel radio telecommunication apparatus as claimed in claim 5, characterized in that an adaptation stage (27) is connected to the input of the digital-to-analog converter (28) for the purpose of adaptation to the PROM storage circuit (15).

7. A multi-channel radio telecommunication apparatus as claimed in claim 6, characterized in that the adaptation stage (27) is a buffer circuit for level adaptation between the PROM storage circuit (15) and the digital-to-analog converter (28).

8. A multi-channel radio telecommunication apparatus as claimed in claim 6, characterized in that the adaptation stage (27) is a digital value converter which converts the first digital value such that it falls within the operating range of the digital-to-analog converter (28).

9. A multi-channel radio telecommunication apparatus as claimed in one of the claims 1 to 7, characterized in that the reference voltage (U$_{ref}$) and the analog voltage (U$_a$) are each fed to a respective input of an operational amplifier (26) which is wired as a differential amplifier and whose output voltage is the control voltage (U$_{St}$) for the selection circuit (31) or the selection circuits.

## Revendications

1. Radiophone multicanaux pour les modes d'exploitation »duplex« et/ou »alternat conditionnel« avec un circuit de mémoire PROM (programmable-read-only-memory-) (15), qui délivre un circuit d'oscillateur PLL (phase-locked-loop) (18), une première valeur numérique caractérisant la fréquence choisie et une seconde valeur numérique correspondant à la grille de canaux prédéfinis et mémorisés dans le circuit de mémoire PROM, le circuit d'oscillateur PLL alimentant un étage mélangeur de la partie réceptrice, radiophone caractérisé en ce que la première et la seconde valeurs numériques ainsi qu'une troisième valeur numérique caractérisant le mode d'exploitation, et également délivrée par le circuit de mémoire PROM (15) ou bien par le commutateur de mode d'exploitation (12), sont appliquées au circuit PLL (18) ainsi qu'à un circuit de combinaison logique (22), qui, à partir de ces valeurs digitales délivre une tension de commande correspondante (U$_{St}$) à au moins un circuit de sélection (31), susceptible d'être accordé électroniquement sur la fréquence de réception, de la partie réceptrice du radiophone.

2. Radiophone multicanaux selon revendication 1, caractérisé en ce que le circuit de combinaison logique (22) comporte des moyens de commutation grâce auxquels, par formation de différence entre une tension de référence (U$_{ref}$) dont la grandeur dépend du mode d'exploitation, de la bande de fréquence (bande supérieure, bande inférieure) et de la grille de canaux, et une tension analogique (U$_a$) dérivée de la première valeur numérique, la tension de commande (U$_{St}$) est obtenue.

3. Radiophone multicanaux selon revendication 1 ou 2, caractérisé en ce que le circuit de combinaison logique (22) comporte un dispositif d'exploitation (23) qui, à l'aide des valeurs numériques, effectue en premier lieu la différenciation entre les modes d'exploitation, en ce qu'un second lieu la différenciation selon la bande supérieure et la bande inférieure, et en troisième lieu la différenciation selon la grille de canaux, et qui délivre à ces sorties, les signaux numériques de commande correspondants.

4. Radiophone multicanaux selon revendication 1 ou 2, caractérisé en ce que le circuit de combinaison logique (22) comporte un commutateur de tension de référence (24) qui en fonction des signaux de commande du dispositif d'exploitation (23) délivre à sa sortie (25) une tension de référence déterminée (U$_{ref}$).

5. Radiophone multicanaux selon revendication 1, 2 ou 3, caractérisé en ce que le circuit de combinaison logique (22) comporte un convertisseur numérique/analogique (28) qui convertit la première valeur numérique en une tension analogique (U$_a$).

6. Radiophone multicanaux selon revendication 5, caractérisé en ce qu'un étage d'adaptation (27) est branché en amont du convertisseur numérique/analogique (28) pour permettre son adaptation au circuit de mémoire PROM (15).

7. Radiophone multicanaux selon revendication 6, caractérisé en ce que l'étage d'adaptation (27) est un circuit tampon (buffer circuit) pour l'adaptation du niveau entre le circuit de mémoire PROM (15) et le convertisseur numérique/analogique (28).

8. Radiophone multicanaux selon revendication 6, caractérisé en ce que l'étage d'adaptation (27) est un convertisseur de valeur numérique, qui convertit la première valeur numérique de façon qu'elle se situe dans le champ d'action du convertisseur numérique/analogique (28).

9. Radiophone multicanaux selon l'une des revendications 1 à 7, caractérisé en ce que la tension de référence (U$_{ref}$) et la tension analogique (U$_a$) sont chacune appliquées à une entrée d'un amplificateur opérationnel (26) branché en amplificateur différentiel, dont la tension de sortie constitue la tension de commande (U$_{St}$) pour le circuit de sélection (31) ou bien les circuits de sélection.

Fig. 1

Fig. 2

(31)

TBB 1458

2 x SLC 4050

SE 5008

+U

S 187 C

S 353

15

18

21

23

24

27

28

35

36  37

39

38  40  41  43  44  45  46  47  48

42